(19) Europäisches Patentamt / European Patent Office / Office européen des brevets

(11) **EP 2 188 986 B1**

## (12) EUROPEAN PATENT SPECIFICATION

(45) Date of publication and mention
of the grant of the patent:
**06.04.2016 Bulletin 2016/14**

(21) Application number: **08827901.3**

(22) Date of filing: **15.08.2008**

(51) Int Cl.:
*H03G 9/00* *(2006.01)*  *H04N 21/439* *(2011.01)*
*H04S 7/00* *(2006.01)*  *H03G 9/02* *(2006.01)*
*H04N 5/60* *(2006.01)*

(86) International application number:
**PCT/US2008/073299**

(87) International publication number:
**WO 2009/026143 (26.02.2009 Gazette 2009/09)**

(54) **AUDIO PROCESSING FOR COMPRESSED DIGITAL TELEVISION**

TONVERARBEITUNG FÜR KOMPRIMIERTES DIGITALES FERNSEHEN

TRAITEMENT AUDIO POUR LA TÉLÉVISION NUMÉRIQUE COMPRESSÉE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **16.08.2007 US 964930 P**

(43) Date of publication of application:
**26.05.2010 Bulletin 2010/21**

(73) Proprietor: DTS, Inc.
**Calabasas, CA 91302 (US)**

(72) Inventors:
• **THOMPSON, Jeffrey
Bothell, WA 98011-2283 (US)**

• **REAMS, Robert
Mill Creek, WA 98012 (US)**

(74) Representative: **Müller, Wolfram Hubertus et al
Patentanwalt
Teltower Damm 15
14169 Berlin (DE)**

(56) References cited:
WO-A1-2006/047600     WO-A2-2004/111994
KR-A- 940 017 879     KR-A- 950 010 626
KR-A- 20000 067 687

## Description

### FIELD OF THE INVENTION

The invention relates to volume control for broadcast signals.

### BACKGROUND OF THE INVENTION

Volume control is still a real issue within the broadcaster community. The viewer really does "change channels" if they become annoyed enough. The integration of "modern" high dynamic range content with (lower dynamic range) legacy content and loud blaring (high density) commercials is effectively "viewer repellant".

There is working metadata technology that takes this problem into consideration, however, there are metadata integration challenges between the content and the consumer as well as legacy content issues (pre-existing content that has no associated metadata).

At one time SMPTE standardized -20 dBFS as the "operating level" for digital audio systems and established VU zero as -20dBFS to produce typical PPM peaks of about -10 dBFS for VU peaks of 0. There appeared to be difficulty maintaining this as a consensus so dialog normalization was made variable within a range from -31 dBFS to -1 dBFS. Although a dialnorm meter has become commercially available, proper dialnorm measurement requires choosing a suitable portion of dialog within the program and relies on the discretion of the operator while monitoring in a highly controlled environment. These measurements require a skilled operator with the time to perform a complete level assessment of every show, which is not possible in a broadcast environment. Only after all goes well and all of these conditions are met, dialnorm must then pass intact to all destination decoders.

Document WO 2006/047600 A1 discloses controlling the specific loudness of an audio signal. A perceptual loudness estimation signal for one audio channel is discussed. Gain control is applied to the signal.

### SUMMARY OF THE INVENTION

In accordance with the present invention, a system for controlling volume with the features of claim 1 and a method for controlling volume with the features of claim 6 are provided.

Those skilled in the art will further appreciate the advantages and superior features of the invention together with other important aspects thereof on reading the detailed description that follows in conjunction with the drawings.

### BRIEF DESCRIPTION OF THE SEVERAL VIEWS OF THE DRAWINGS

FIGURE 1 is a diagram of a compression profile

FIGURE 2 is a diagram of equal loudness curves

FIGURE 3 is a diagram of an equal loudness filter;

FIGURES 4A-4C are histograms of RMS energy values in 3 audio tracks;

FIGURE 5 is a diagram of an interim processor

FIGURE 6 is a diagram of dynamic range contours (DRC)

FIGURE 7 is a day-parting schedule represented by day and time (15 minute military time intervals);

FIGURE 8 is a diagram of a consumer "volume-lock" function;

FIGURE 9 is a diagram of a system for loudness control in accordance with an exemplary embodiment of the present invention;

FIGURE 10 is a diagram of a system for perceptual loudness estimation in accordance with an exemplary embodiment of the present invention;

FIGURE 11 is a diagram of a system for perceptual flatness scaling in accordance with an exemplary embodiment of the present invention; and

FIGURE 12 is a diagram of a system for performing loudness leveling in accordance with an exemplary embodiment of the present invention.

### DETAILED DESCRIPTION OF PREFERRED EMBODIMENTS

In the description that follows, like parts are marked throughout the specification and drawings with the same reference numerals, respectively. The drawing figures might not be to scale, and certain components can be shown in generalized or schematic form and identified by commercial designations in the interest of clarity and conciseness.

Generally, the overall shape of the loudness control transfer function is where problems may develop. A default "target map" of the program dynamics can be defined and maintained in the absence of metadata. In the presence of valid metadata the target map can be transformed into the compression profile described by the metadata. If the metadata vanishes or become corrupt, the compression profile is transformed back into the default target map.

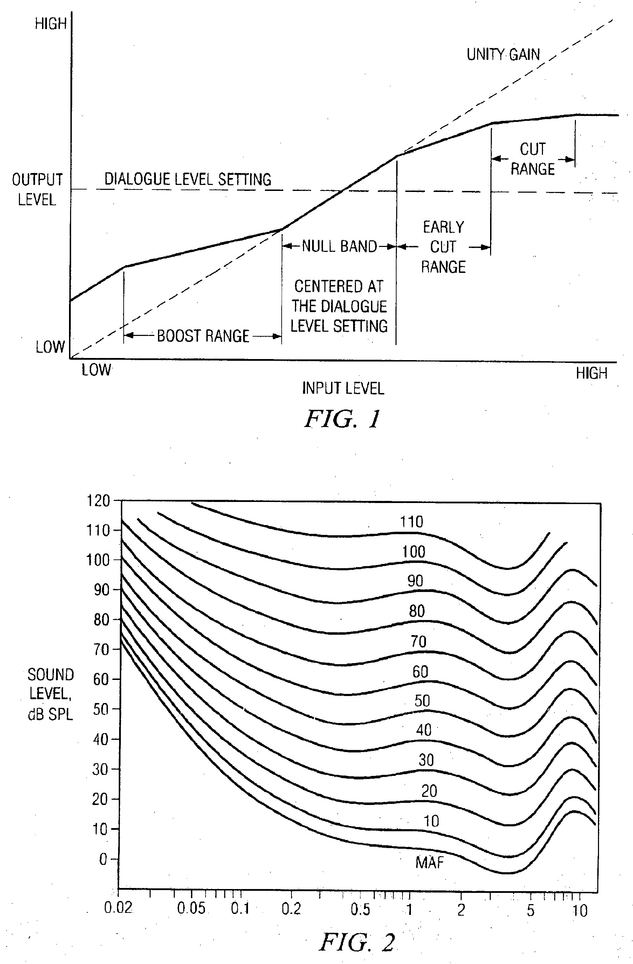

FIGURE 1 is a diagram of a compression profile. Maintaining the long term perceived loudness (the center of the "full band" within the compression profile) of the overall program under all conditions is a desirable feature. Although instantaneous correction is not possible, satisfactory (local) null band gain normalization is achievable if the recovery/reduction ballistics are shaped according to psychoacoustic principles.

The broadcast engineer then has a choice to override the local norm in the presence of valid metadata. This feature allows the station to back out the local norm and the default target map features as metadata becomes better understood and more reliable. If all goes well, maintenance of a local compression profile target map and null band gain normalization will become unnecessary with the exception of the stations that set station-specific dynamics preferences.

Volume normalization deals with the head end ingest of the audio content. At this stage, the content is normalized using a psychoacoustic model with statistical processing to assure that the long term perceived loudness is consistent. Described herein are exemplary components that can be used to accomplish automatic normalization.

**FIGURE 2** is a diagram of equal loudness curves. The equal loudness contours were measured by Robinson and Dadson in 1956, based on original measurements carried out by Fletcher and Munson in 1933, and the curve often carries their name.

The lines represent the sound pressure required for a test tone of any frequency to sound as loud as a test tone of 1 kHz. Take the line marked "60" - at 1 kHz ("1" on the x axis), the line marked "60" is at 60dB (on the y axis). Following the "60" line down to 0.5 kHz (500 Hz), the y axis value is about 55 dB. Thus, a 500 Hz tone at 55 dB SPL sounds as loud to a human listener as a 1 kHz tone at 60 dB SPL. This principle is used to control volume levels.

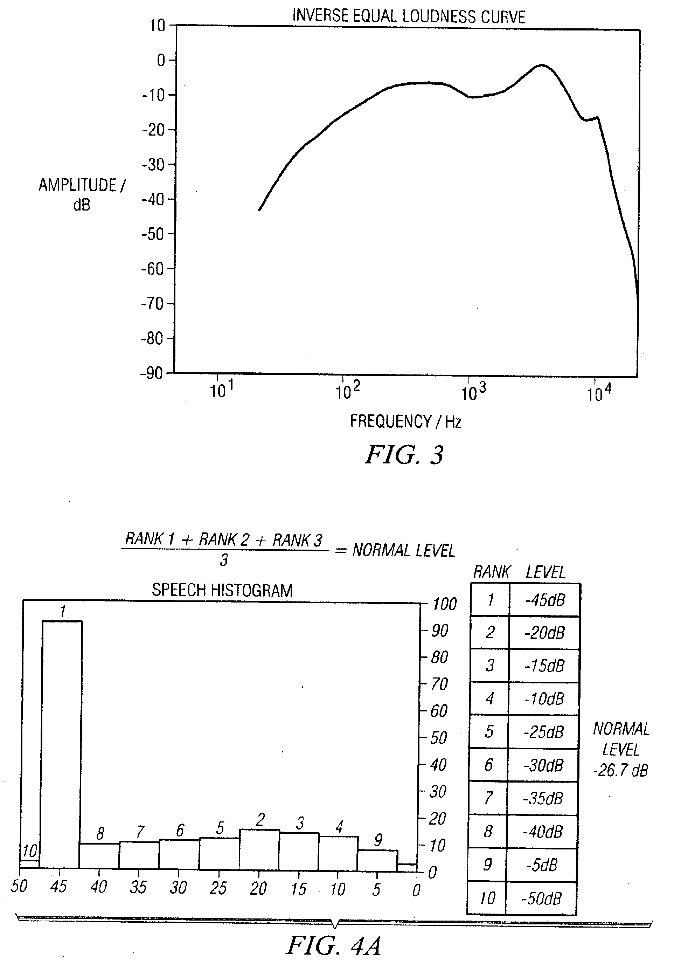

**FIGURE 3** is a diagram of an equal loudness filter. Where the lines curve upwards, there is less sensitive to sounds of that frequency. Hence, the filter attenuates sounds of that frequency. The ideal filter is the inverse of the equal loudness filter. As the replay level is not known, and different filter for sounds of differing loudness is not desirable, a representative average of the curves can be chosen as the target filter.

While the RMS energy over an entire audio file can be calculated, this value doesn't give a good indication of the perceived loudness of a signal, although it is closer than that given by the peak amplitude. By calculating the RMS energy on a moment by moment basis, a better solution can be accomplished using the following process:

- The signal is sampled in 50 ms long blocks.
- Every sample value is squared.
- The mean average is taken.
- The square root of the average is calculated.

With these four steps the RMS value for each 50 ms block can be used for further processing.

The block length of 50 ms was chosen after studying the effect of values between 25 ms and one second. 25 ms was observed to be too short to accurately reflect the perceived loudness of some sounds. Beyond 50 ms, it was observed that there was little change after statistical processing. For this reason, 50 ms was chosen.

There is difficulty in what to do with stereo files. They can be summed to mono before calculating the RMS energy, but then any out-of-phase components (having the opposite signal on each channel) would cancel out to zero (i.e. silence). As that is not how they are perceived, that process is not a good solution.

An alternative is to calculate two RMS values, one for each channel, and then add them. Unfortunately, linear addition still doesn't give the same effect that the listener hears. To demonstrate this, consider a mono (single channel) audio track. When it is replayed over one loudspeaker and compared to sound replayed over two loudspeakers, linear addition would suggest that it would be half as loud, but the observed volume is 0.75 times as loud.

Perceptually, a closer representation is achieved if the means of the channel-signals are added before calculating the square root. In pan-pot terms, that means using "equal power" rather than "equal voltage". If it is also assumed that any mono (single channel) signal will be replayed over two loudspeakers, the mono signal can be treated as a pair of identical stereo signals. As such, a mono signal gives (a+a)/2 (i.e. a), while a stereo signal gives (a+b)/2, where a and b are the mean squared values for each channel. After this, the square root is carried and converted to dB.

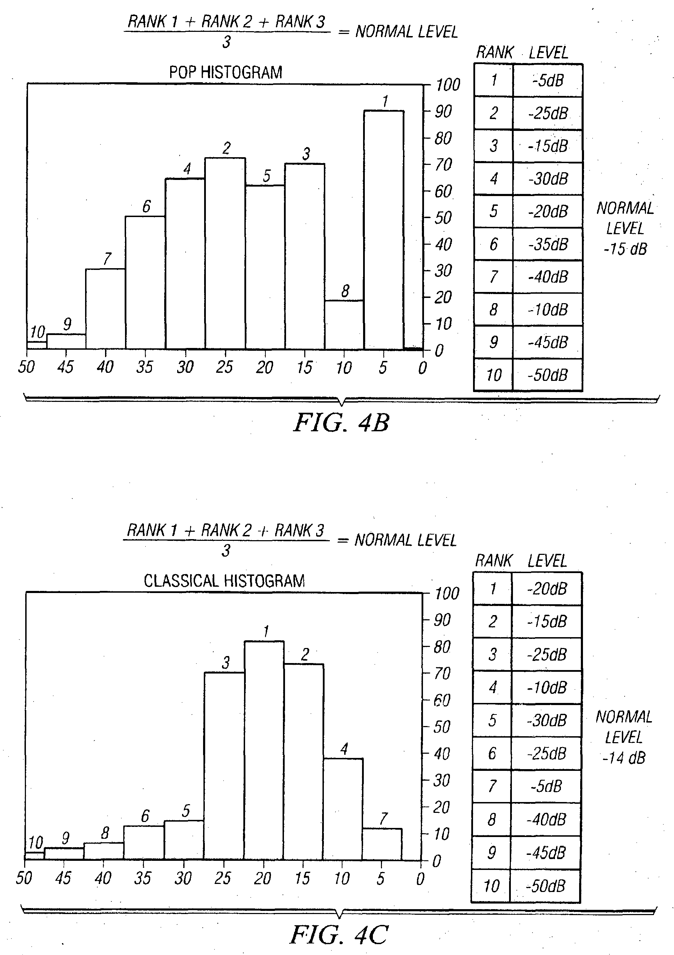

**FIGURES 4A-4C** are histograms of RMS energy values in 3 audio tracks. FIGURE 4A represents speech, FIGURE 4B represents pop music, and FIGURE 4C represents classical music. Having calculated RMS signal levels every 50ms through the file, a single value of offset can be determined to represent the perceived loudness of the entire file. The exemplary histograms show how many times each RMS value occurred in each file.

The most common RMS value in the speech track was 45dB (background noise), so the most common RMS value is clearly not a good indicator of perceived loudness. The average RMS value is similarly misleading with the speech sample, and also with classical music.

Instead, a good method to determine the overall perceived loudness is to rank the RMS energy values into numerical order, and then average the values near the top of the list.

In order to determine how far down the sorted list a representative value is, for the highly compressed pop music of FIGURE 4B, the choice makes little difference. For speech and classical music, the choice makes a huge difference. The value which most accurately matches human perception of perceived loudness can be calculated as follows:

$$\frac{Rank\ 1 + Rank\ 2 + Rank\ 3}{3} = Normal\ Level$$

Having calculated the "normal level" of the content, the long term volume is then increased or reduce to meet the selected normalization level of -21dBFS. Using this method, the speech piece would be brought up by 5.7dB, the pop piece down by 6dB and the classical piece down by 7dB.

The normalized content is then stored to the server, playout or any other mass memory residing at the head-end, or in many cases, at the affiliate.

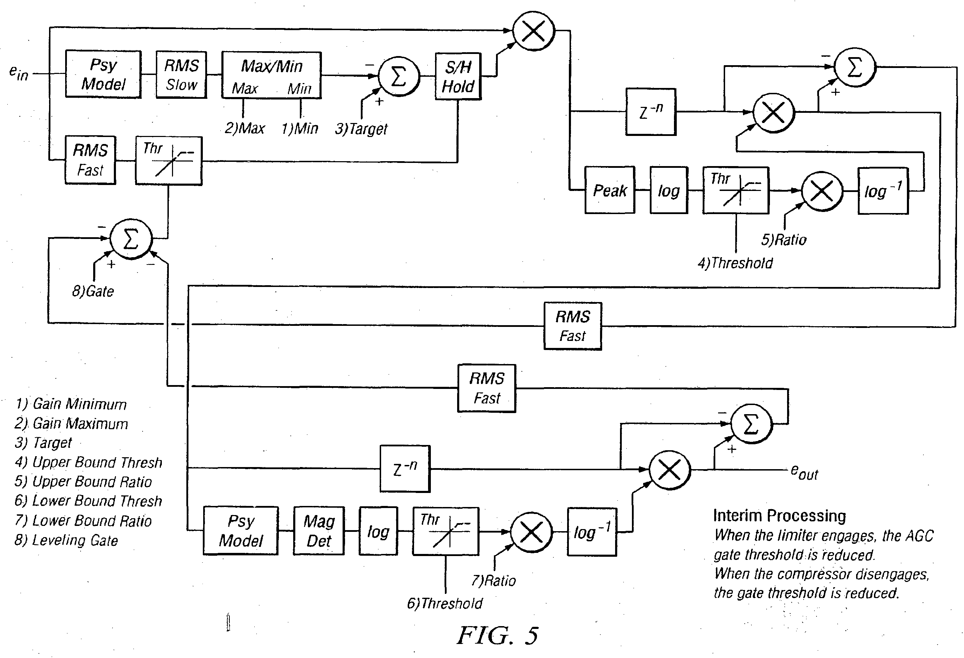

**FIGURE 5** is a diagram of an interim processor. Assuming that the content has been normalized at both the head end and the local affiliate, the interim processor is relieved of long term volume control duties. That being said, it is now up to the interim processor (IP) to control both startling increases and perplexing decreases in the audio content. To accomplish this, control of the upper and lower boundaries of the content that track the pre-normalized level of the content can be used. The IP can continuously track the long term level of the content and adjust the boundaries and keep them "out of the way" to maintain complete transparency. One exemplary way to accomplish this task is to have the upper and lower boundary limits "float" along with the content envelope. As long as the short term dynamics stay within the first derivative of the long term envelope, no action is taken.

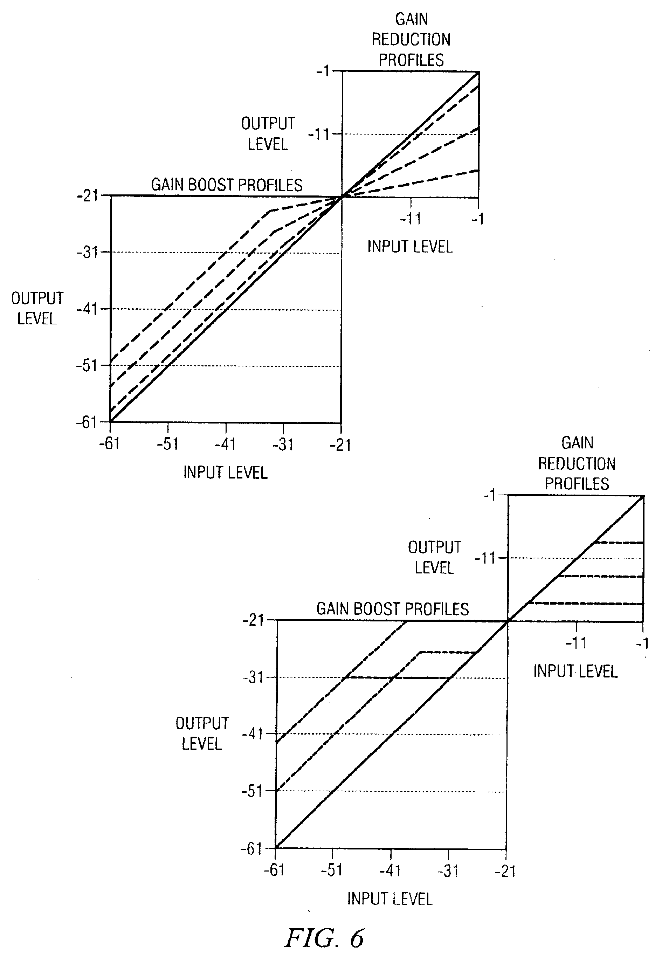

**FIGURE 6** is a diagram of dynamic range contours (DRC) in accordance with an exemplary embodiment of the present invention. The DRC defines the dynamic "character" of the content. The contour allows the affiliate the ability to adjust the dynamics of the content to better match the viewer demograph in a given time slot. Even when metadata based systems are correct, one size does not fit all when crossing several time zones. This condition can be alleviated through day-parting the DRC and giving the control to the affiliate. In this manner, the programming, being known ahead of time, may be controlled in a sensible and predictable manner, taking into consideration that wide dynamic range blockbuster movies aren't as appreciated in the early morning or late evening and talk or "judge" shows are to be closely regulated as to not lose any dialog. This process is accomplished by providing adjustable control over the upper and lower boundaries of the content.

Note that the boost and reduction contours are centered around -21dBFS. This level was determined to be of optimal benefit to both legacy and properly ingested content. Depending on the dynamic range contour selected, the "deadband", the part of the transfer function that is completely transparent, is sized to elicit just the right amount of control on the content. As seen in FIGURE 6, the gain boost profile may be handled by an ordinary AGC while the gain reduction profile be performed by compression and limiting.

The yellow contour corresponds to compression, the green contour corresponds to an AGC function and the red contour is a result of limiting. It is easy to see how assembling an appropriate DRC can be made quite simple.

DRC "A" represents a tightly controlled contour demonstrating a dynamic range of 4dB over a 47dB range. This DRC is extreme, but might have applications in delivery of "mission critical" dialog. DRC "B" demonstrates less control; 20dB over a 40dB range. This contour would be representative of a medium range movie.

The "alarm" feature of the interim processor activates anytime the content drifts into the red or green portions of the contour. During this process, the long term gain is adjusted until the content level is "centered" in the yellow zone. At this point the alarm function deactivates until another deviation from the low distortion yellow zone is detected. During the time that the AGC is engaged, an alarm is activated to notify the operator of the deviation and the time of the alarm is logged.

It is difficult for audio related meta-data based systems to anticipate the time zones of the consumers at the other end of the content journey. In light of this reality, the IP is driven by a local day-parting, or scheduling system that allows the affiliate to control the volume boundaries as a function of time of day. Since the type and scheduling of local content is highly controlled, it is simple for the affiliate to day-part the processing to match both the type of content (talk, action, cartoons, soaps) and the time of day (more controlled in the early morning and late night).

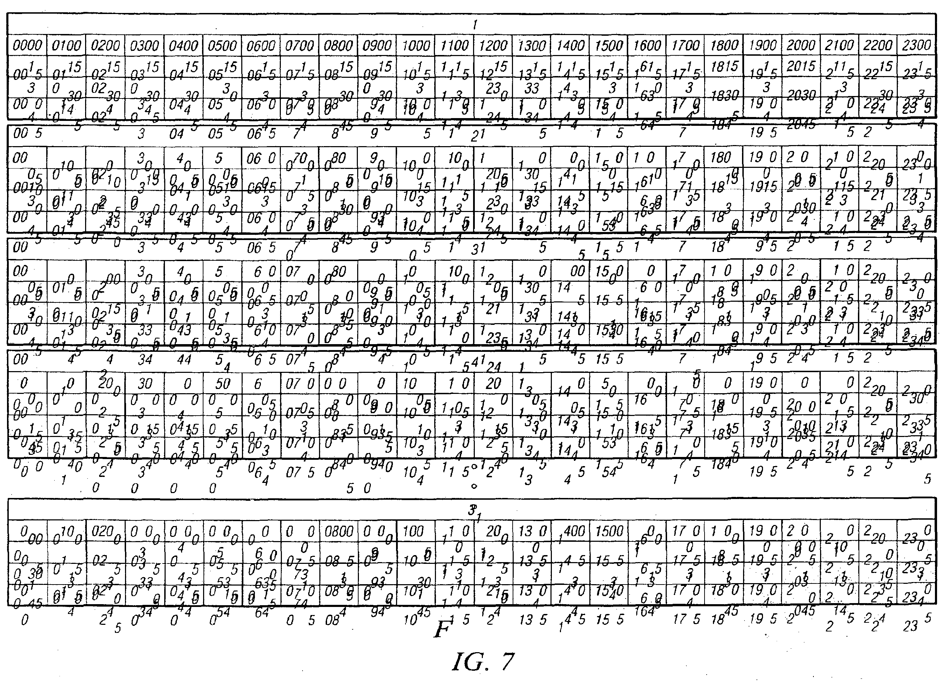

**FIGURE 7** is a day-parting schedule represented by day and time (15 minute military time intervals). Days can be copied into other days to save editing time. The day-part schedule can be remotely editable (such as via Internet protocol) for special events or sudden changes in schedule. Each day/time represents a preset. Each preset represents a particular dynamic range contour that is programmable. Once a day-parting schedule has be written, it only needs to be changed or updated a few times a year.

The IP may also employ additional processing to increase the listening enjoyment of the content, even when the content is flawed. De-humming and de-noising are useful tools for older content while temporal and intensity normalization are helpful to an affiliate that is still broadcasting Left-Right based content mixed with stereo content.

At the consumer end, a final perceptual volume control or lock can be provided. The main purpose of this volume lock is to give the consumer final control over the dynamic range contour and level of the content. The conditions of the consumer are impossible to predict in that the consumer may have an ultimate home theater or just a small mono TV. The consumer may live in a very noisy environment or may be hard of hearing. The consumer may have young children that are asleep or an elderly relative that is both hard of hearing and easily startled. Volume lock provides a simple solution to the consumer with a simple selection of the volume and one of three dynamic ranges (wide, average and narrow).

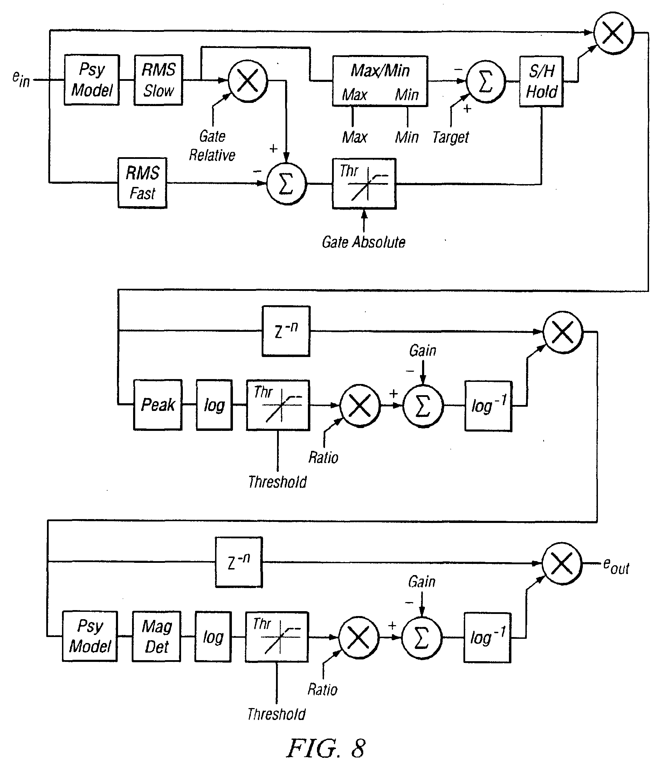

**FIGURE 8** is a diagram of a consumer "volume-lock" function. The AGC target and compressor and limiter threshold functions are "ganged" to allow easy setting of the desired volume level. Three local presets allows the consumer the choice of narrow, medium or wide dynamic range contours. In the "wide" mode, the consumer is choosing to trust the broadcast as is. In the "medium" mode, the consumer is may enjoy a variety of programming under loose control. The "narrow" mode is useful for talk shows or soap operas interspersed with abusively loud commercials.

The information gathered points toward a three part system: ingest, interim processing with day parting and consumer control. Any one of these three processes should benefit the consumer experience on it's own merit. Combined, they provide a fail safe environment for the audio portion of the content, free from startling level jumps or drop offs. The system operates with any legacy infrastructure and does not depend on metadata to control normalized level or dynamic range contour. It provides improved performance for loud commercials or head end and affiliate errors. If ingest and interim processing protocol are followed, there is no need for consumer processing except for convenience. The system is autonomous, needing no human intervention, once content is ingested and interim process day-parting is programmed. In the absence of properly ingested content, the interim processing intelligently controls level with only minuscule and very short term tracking error.

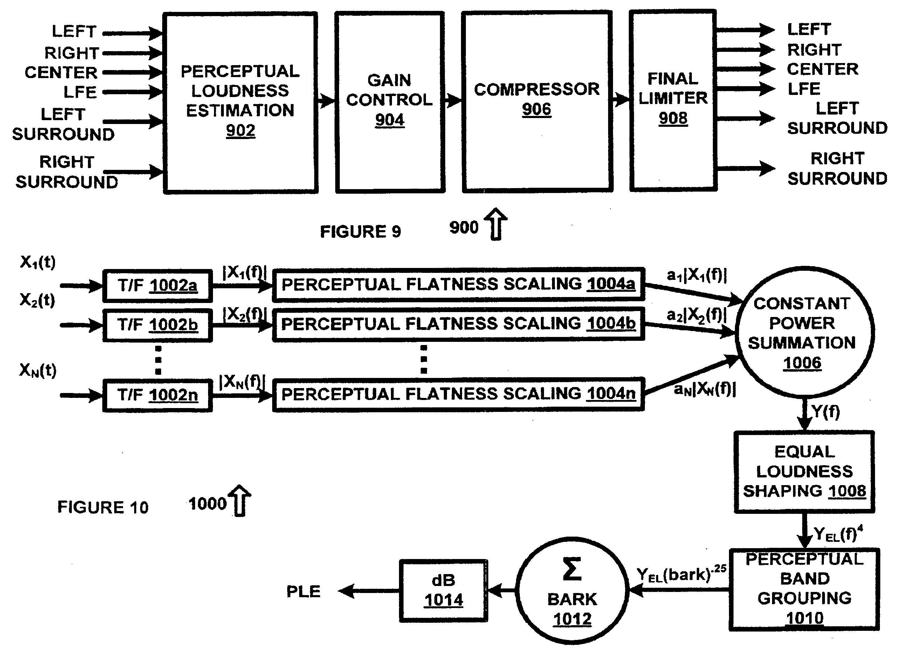

**FIGURE 9** is a diagram of a system 900 for loudness control in accordance with an exemplary embodiment of the present invention. System 900 includes perceptual loudness estimation 902, gain control 904, compressor 906 and final limiter 908, each of which can be implemented in hardware, software or a suitable combination of hardware and software, and which can be one or more software systems operating on a general purpose processing platform. As used herein, "hardware" can include a combination of discrete components, an integrated circuit, an application-specific integrated circuit, a field programmable gate array, or other suitable hardware. As used herein, "software" can include one or more objects, agents, threads, lines of code, subroutines, separate software applications, two or more lines of code or other suitable software structures operating in two or more software applications or on two or more processors, or other suitable software structures. In one exemplary embodiment, software can include one or more lines of code or other suitable software structures operating in a general purpose software application, such as an operating system, and one or more lines of code or other suitable software structures operating in a specific purpose software application.

Perceptual loudness estimation system 902 uses psychoacoustic and signal processing techniques to accurately detect and regulate the perceived loudness of a suitable source, such as the exemplary 5.1 source shown in FIGURE 9. Likewise, sound sources such as mono signals, stereo signals, 7.1 signals, or other suitable signals can be processed.

Gain control system 904 is used to increase or decrease the gain of the signal to modify the loudness, based on the output from perceptual loudness estimation system 902, predetermined loudness constraints, or other suitable factors.

Compressor 906 can be used to control short-term loudness variations that are not adequately processed by perceptual loudness estimation system 902 and gain control system 904. In one exemplary embodiment, compressor 906 can be set to allow a predetermined allowable short term peak above a predetermined target level, such as 2 dB to 8 dB. Compressor 906 can apply a compression ratio over a user-selected range, such as 0.40 to 0.80.

Final limiter 908 can be used to control absolute waveform peak levels. In one exemplary embodiment, final limiter 908 can be user selectable over a predetermined range, such as -10 dB full scale (FS) to 0 dBFS.

In operation, system 900 allows loudness to be controlled at a broadcast system or other suitable locations, such as by using psychoacoustic and signal processing techniques to accurately detect and regulate the perceived loudness of a sound source, in combination with other suitable loudness controls such as compressors and limiters. By combining psychoacoustic and signal processing techniques with other suitable loudness controls, system 900 avoids over-compensation of loudness, such as where soft dialog is offset against periodic loud noises, such as gun shots, crashes, explosions, or other desired content.

**FIGURE 10** is a diagram of a system 1000 for perceptual loudness estimation in accordance with an exemplary embodiment of the present invention. Audio channels $x_1$ (t) through $x_N$(t) of the source audio signal, where N is a suitable integer representing the number of channels of source audio data, are processed through complex time-to-frequency filter banks 1002a through 1002n, which convert the time domain signals $x_1$(t) through $x_N$(t) to corresponding frequency domain signals $x_1$(f) through $x_N$(f). The magnitude of each sub-band $|X_1(f)|$ through $|X_N(f)|$ is then input to a corresponding perceptual flatness scaling 1004a through 1004n, which generates a scaling value $a_1$ through $a_N$ that is applied to the magnitude of each corresponding sub-band.

After the audio spectrum of each channel has been scaled proportionally to a perceptual flatness measure, all of the channels $a_1 |X_1(f)|$ through $aN|X_N(f)|$ I are summed by constant power summation 1006, such as in accordance with the following equation:

$$Y(f) = \sqrt{\sum_{i=1}^{N} (a_i \,|\, X_i(f)|)^2}$$

The constant power summation is derived from constant power panning laws and can be used to model the sound power level for each sub-band that would exist in the listening "sweet-spot" if the audio signal were to be played back over loudspeakers. Using a constant power summation to model the sound power level provides for a perceptually appropriate method for summing channels as well as affording the scalability in number of input channels. Constant power summation 1006 outputs combined audio spectrum Y(f).

Equal loudness shaping 1008 processes the combined audio spectrum Y(f) using an equal loudness contour, such as the Fletcher-Munson curves or other suitable equal loudness contours, which model the phenomena that for a typical human listener different frequencies are perceived at different loudness levels. For example, for a given sound pressure level (SPL), an average listener will perceive that the mid-frequencies around 1-4 kHz will be louder than the low or high frequencies. Equal loudness shaping 1008 generates equal loudness shaped spectrum $Y_{EL}(f)$.

Each sub-band of the equal loudness shaped spectrum $Y_{EL}(f)$ is raised to the fourth power and then grouped into perceptual bands by perceptual band grouping 1010. The raising of the spectrum $Y_{EL}(f)$ to the fourth power is performed to compensate for the subsequent processing where the banded spectrum $Y_{EL}(bark)$ is raised to the 0.25 power. All compressed perceptual bands $Y_{SL}(bark)$ 0.25 are then summed by summation 1012 and converted to dB resulting in a perceptual loudness estimate PLE for the given audio segment.

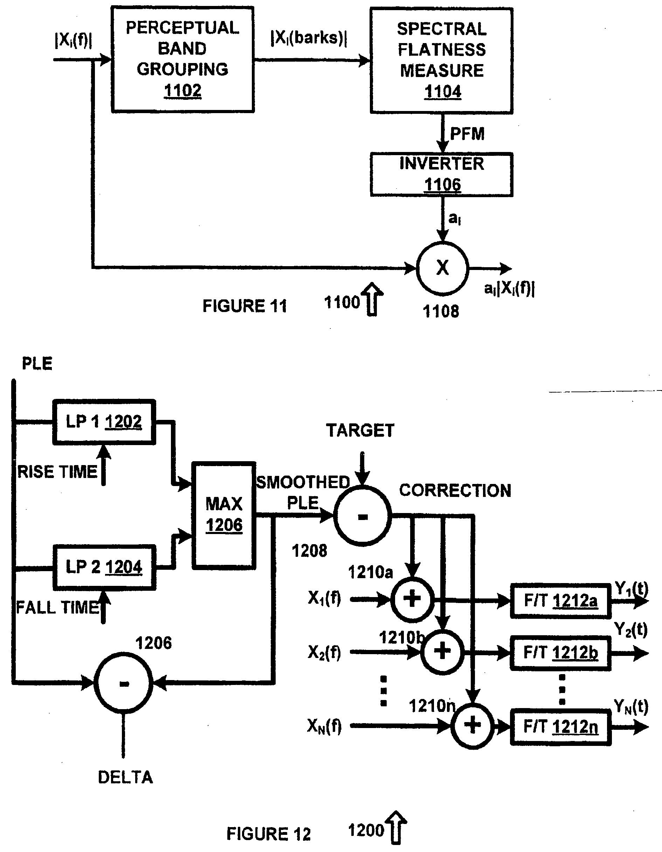

**FIGURE 11** is a diagram of a system 1100 for perceptual flatness scaling in accordance with an exemplary embodiment of the present invention. Perceptual band grouping 1102 groups the spectrum $|X_1(f)|$ into perceptual bands and generates an output $|X_1(barks)|$. Spectral flatness measure 1104 computes a spectral flatness measure on the perceptual bands $|X_1(barks)|$ resulting in a perceptual flatness measure PFM. A high perceptual flatness measure indicates that the signal has nearly equal amounts of energy in all perceptual bands, likely sounding similar to pink noise. A low perceptual flatness measure indicates that the signal energy is concentrated into a small number of perceptual bands, likely sounding similar to a mixture of tones.

The perceptual flatness measure PFM is then converted to a scaling value $a_i$ by inverter 1106, which is used to scale the entire spectrum of $|X_1(f)|$ by multiplier 1108. When PFM is high, the scaling factor $a_i$ should be low, and when PFM is low, the scaling value $a_i$ should be high, based on the empirical observation that broadband and perceptually flat signals typically have energy levels which are too high relative to their perceived loudness. In one exemplary embodiment, the scaling values $a_i$ can range from -6dB for perceptually flat material to 0dB for perceptually tonal material.

FIGURE 12 is a diagram of a system 1200 for performing loudness leveling in accordance with an exemplary embodiment of the present invention. System 1200 smoothes short-term perceptual loudness estimates (PLEs) received from perceptual loudness estimation system 902 through simple first-order low-pass filters.

The TARGET perceived loudness level input to subtractor 1208 can be predetermined, set by a user, or otherwise determined. Because an end-user playback volume level is unknown, the target loudness level can be set in dBFS rather than SPL. For example, if a user selects a target loudness level to be -20 dBFS, the corrected audio signal will have a long-term average level of -20 dBFS while maintaining equal perceived loudness.

System 1200 includes filters LP 1 1202 and LP 2 1204, which can be first-order infinite impulse response low-pass filters or other suitable filters. The PLE value is sent through both filter LP1 1202 and filter LP2 1204 and the maximum output is chosen by max 1206 as the smoothed PLE value. In practice, rise time values are used that are faster than fall time values. This process results in the rise time filter LP1 1202 controlling onset events, and the fall time filter LP2 1204 controlling decay events.

A feedback loop is present to provide variable speed processing to the loudness correction. A DELTA value is computed as shown in Figure 12. When the DELTA value exceeds a predetermined or user-defined threshold, the cutoff frequencies for filter LP1 1202 and filter LP2 1204 are set to predetermined or user-defined values of $Fast_{RT}$ and $Fast_{FT}$, respectively. When the value of DELTA value falls below the threshold, the cutoff frequencies are set to predetermined or user-defined values of $Slow_{RT}$ and $Slow_{FT}$. Incorporating this simple feedback loop and variable speed smoothing helps to capture sharp loudness onsets when they occur.

The final correction value is computed as a difference between the TARGET value and the smoothed PLE value by subtractor 1208. This correction value is then applied to all channels of the source signal $x_1(f)$ through $x_N(f)$ by adders 1210a through 1210n, and the loudness-corrected output signals $y_1(t)$ through $y_N(t)$ are generated by frequency to time transforms 1212a through 1212n, respectively.

Although exemplary embodiments of a system and method of the present invention have been described in detail herein, those skilled in the art will also recognize that various substitutions and modifications can be made to the systems and methods without departing from the scope of the appended claims.

**Claims**

1. A system for controlling volume, comprising:

   a perceptual loudness estimation unit (902) adapted to determine a perceptual loudness estimate for a given audio segment, the audio segment comprising an audio channel; and
a gain control unit (904) adapted to receive the perceptual loudness estimate and adapted to adjust a gain of the audio channel of the audio segment,

**characterized in that**
the gain control unit (904) comprises

- a first low-pass filter (1202) and a second low-pass filter (1204), each adapted to smooth the received perceptual loudness estimate;
- a max unit (1206) adapted to choose the maximum output of the first low-pass filter (1202) and the second low-pass filter (1204) as a smoothed perceptual loudness estimate value; and
- a feedback loop adapted to generate a difference value from the received, perceptual loudness estimate value and the smoothed perceptual loudness estimate value chosen by the max unit (1206) and adapted to set the cutoff frequencies for both of the low-pass filters (1202, 1204) to first predetermined or user-defined values if the difference value exceeds a predetermined threshold, and adapted to set the cutoff frequencies for both of the low-pass filters (1202, 1204) to second predetermined or used-defined values if the difference value is below the predetermined threshold;

wherein the gain control unit (904) is adapted to adjust the gain of the audio channel of the audio segment as a function of the smoothed perceptual loudness estimate value and as a function of a target perceptual loudness level (TARGET), wherein a gain correction value is computed as a difference between the smoothed perceptual loudness estimate value and the target perceptual loudness level (TARGET) and the gain correction value is added to the audio channel in the frequency domain.

2. The system of claim 1, wherein the perceptual loudness estimation unit (902) further comprises a plurality of perceptual flatness scaling units (1004a, ..., 1004n), each for receiving magnitude data for a sub-band of the audio channel, generating a corresponding scaling value, and multiplying the magnitude data by the corresponding scaling value to generate a plurality of scaled sub-band magnitudes, wherein

- the perceptual loudness estimation unit (902) further comprises a constant power summation unit (1006) for receiving the plurality of scaled sub-band magnitudes and generating a combined audio spectrum, and
- the perceptual loudness estimation unit (902) is further adapted to determine the perceptual loudness estimate in dependence of the generated combined audio spectrum.

3. The system of claim 2, wherein the combined audio spectrum is determined in accordance with the equation:

$$Y(f) = \sqrt{\sum_{i=1}^{N} (a_i |X_i(f)|^2)} \text{ , wherein}$$

$Y(f)$ represents the combined audio spectrum;
$N$ is an integer representing the number subbands;
$i$ is a natural number in between 1 and N;
$a_i$ represents the scaling value for each subband; and
$|X_i(f)|$ represents the magnitude of each subband.

4. The system of claim 2, further comprising an equal loudness shaping system (1008) for receiving the combined audio spectrum and generating an equal loudness shaped spectrum by scaling the combined audio spectrum by an equal loudness contour.

5. The system of claim 4, the perceptual loudness estimation unit (902) is further adapted to determine the perceptual loudness estimate in dependence of the equal loudness shaped spectrum.

6. A method for controlling volume, comprising:

determining a perceptual loudness estimate for a given audio segment, the audio segment comprising an audio channel;
receiving the perceptual loudness estimate at a gain control unit (904);

**characterized by** the method further comprising:

smoothing, by a first low-pass filter (1202) and a second low-pass filter (1204) of the gain control unit (904), the received perceptual loudness estimate ;
choosing, by a max unit (1206), the maximum output of the first low-pass filter (1202) and the second low-pass filter (1204) as a smoothed perceptual loudness estimate value;
generating a difference value from the received perceptual loudness estimate value and the smoothed perceptual loudness estimate value chosen by the max unit (1206);
setting the cutoff frequencies for both of the low-pass filters (1202, 1204) to first predetermined or user-defined values if the difference value exceeds a predetermined threshold, and setting the cutoff frequencies for both of the low-pass filters (1202, 1204) to second predetermined or used-defined values if the difference value is below the predetermined threshold; and
adjusting a gain of the audio channel of the audio segment as a function of the smoothed perceptual loudness estimate value and as a function of a target perceptual loudness level (TARGET), wherein a gain correction value is computed as a difference between the smoothed perceptual loudness estimate value and the target perceptual loudness level (TARGET) and the gain correction value is added to the audio channel in the frequency domain.

7. The method of claim 6, further comprising:

receiving magnitude data for a plurality of sub-bands of the audio channel;
generating a corresponding scaling value for each of the plurality of sub-bands of the signal;
multiplying the magnitude data by the corresponding scaling value to generate a plurality of scaled sub-band magnitudes;
generating a combined audio spectrum in dependence of the plurality of scaled sub-band magnitudes; and
determining the perceptual loudness estimate in dependence of the generated combined audio spectrum.

8. The method of claim 7, wherein the combined audio spectrum is generated in accordance with the equation: $Y(f) = \sqrt{\sum_{i=1}^{N}(a_i|X_i(f)|^2)}$ , wherein

$Y(f)$ represents the combined audio spectrum;
$N$ is an integer representing the number of sub-bands;
$i$ is a natural number in between 1 and N;
$a_i$ represents the scaling value for each sub-band; and
$|Xi(f)|$ represents the magnitude of each sub-band

9. The method of claim 7, further comprising generating an equal loudness shaped spectrum by scaling the combined audio spectrum by an equal loudness contour.

**Patentansprüche**

1. System zum Regeln der Lautstärke, das Folgendes umfasst:

- eine Wahrnehmungslautheit-Abschätzungseinheit (902), die dafür eingerichtet ist, eine Wahrnehmungslautheit-Abschätzung für ein gegebenes Audiosegment zu bestimmen, wobei das Audiosegment einen Audiokanal umfasst, und,
- eine Verstärkungssteuereinheit (904), die dafür eingerichtet ist, die Wahrnehmungslautheit-Abschätzung zu empfangen, und dafür eingerichtet ist, eine Verstärkung des Audiokanals des Audiosegments einzustellen,

**dadurch gekennzeichnet, dass**
die Verstärkungssteuereinheit (904) Folgendes umfasst:

- einen ersten Tiefpassfilter (1202) und einen zweiten Tiefpassfilter (1204), die jeweils dafür eingerichtet sind, die Wahrnehmungslautheit-Abschätzung zu glätten,
- eine Maximumeinheit (1206), die dafür eingerichtet ist, die maximale Leistung des ersten Tiefpassfilters (1202) und des zweiten Tiefpassfilters (1204) als einen geglätteten Wahrnehmungslautheit-Abschätzungswert auszuwählen, und
- eine Rückkopplungsschleife, die dafür eingerichtet ist, einen Differenzwert aus dem empfangenen Wahrnehmungslautheit-Abschätzungswert und dem durch die Maximumeinheit (1206) ausgewählten geglätteten Wahrnehmungslautheit-Abschätzungswert zu erzeugen, und dafür eingerichtet ist, die Grenzfrequenzen für die beiden Tiefpassfilter (1202, 1204) auf erste vorbestimmte oder benutzerdefinierte Werte festzusetzen, falls der Differenzwert einen vorbestimmten Schwellenwert überschreitet, und dafür eingerichtet ist, die Grenzfrequenzen für die beiden Tiefpassfilter (1202, 1204) auf zweite vorbestimmte oder benutzerdefinierte Werte festzusetzen, falls der Differenzwert unterhalb des vorbestimmten Schwellenwerts liegt,

wobei die Verstärkungssteuereinheit (904) dafür eingerichtet ist, die Verstärkung des Audiokanals des Audiosegments in Abhängigkeit von dem geglätteten Wahrnehmungslautheit-Abschätzungswert und in Anhängigkeit von einem Wahrnehmungslautheit-Zielpegel (TARGET) einzustellen, wobei ein Verstärkungskorrekturwert als eine Differenz zwischen dem geglätteten Wahrnehmungslautheit-Abschätzungswert und dem Wahrnehmungslautheit-Zielpegel (TARGET) berechnet wird und der Verstärkungskorrekturwert zu dem Audiokanal in dem Frequenzbereich addiert wird.

2. System nach Anspruch 1, wobei die Wahrnehmungslautheit-Abschätzungseinheit (902) ferner mehrere Wahrnehmungsflachheit-Skalierungseinheiten (1004a, ..., 1004n), jeweils zum Empfangen von Größendaten für ein Teilband des Audiokanals, Erzeugen eines entsprechenden Skalierungswerts und Multiplizieren der Größendaten mit dem entsprechenden Skalierungswert, um mehrere skalierte Teilbandgrößen zu erzeugen, umfasst, wobei

- die Wahrnehmungslautheit-Abschätzungseinheit (902) ferner eine Dauerleistung-Summierungseinheit (1006) zum Empfangen der mehreren skalierten Teilbandgrößen und Erzeugen eines kombinierten Audiospektrums umfasst und
- die Wahrnehmungslautheit-Abschätzungseinheit (902) ferner dafür eingerichtet ist, die Wahrnehmungslautheit-Abschätzung in Abhängigkeit von dem erzeugten kombinierten Audiospektrum zu bestimmen.

3. System nach Anspruch 2, wobei das kombinierte Audiospektrum bestimmt wird gemäß der Gleichung:

$$Y(f) = \sqrt{\sum_{i=1}^{N} \left(a_i \left| X_i(f) \right| \right)^2} \text{ , wobei}$$

Y(f) das kombinierte Audiospektrum darstellt,
N eine ganze Zahl ist, welche die Anzahl von Teilbändern darstellt,
i eine natürliche Zahl zwischen 1 und N ist,
$a_i$ den Skalierungswert für jedes Teilband darstellt und
$|X_i(f)|$ die Größe jedes Teilbandes darstellt.

4. System nach Anspruch 2, das ferner ein Formungssystem (1008) für gleiche Lautheit zum Empfangen des kombinierten Audiospektrums und Erzeugen eines nach gleicher Lautheit geformten Spektrums durch Skalieren des kombinierten Audiospektrums durch eine Kurve gleicher Lautheit umfasst.

5. System nach Anspruch 4, wobei die Wahrnehmungslautheit-Abschätzungseinheit (902) ferner dafür eingerichtet ist, die Wahrnehmungslautheit-Abschätzung in Abhängigkeit von dem nach gleicher Lautheit geformten Spektrum abzuschätzen.

6. Verfahren zum Regeln der Lautstärke, das Folgendes umfasst:

- das Bestimmen einer Wahrnehmungslautheit-Abschätzung für ein gegebenes Audiosegment, wobei das Audiosegment einen Audiokanal umfasst,
- das Empfangen der Wahrnehmungslautheit-Abschätzung bei einer Verstärkungssteuereinheit (904),

**dadurch gekennzeichnet, dass** das Verfahren ferner Folgendes umfasst:

- das Glätten der Wahrnehmungslautheit-Abschätzung durch einen ersten Tiefpassfilter (1202) und einen zweiten Tiefpassfilter (1204) der Verstärkungssteuereinheit (904),
- das Auswählen der maximalen Leistung des ersten Tiefpassfilters (1202) und des zweiten Tiefpassfilters (1204) als einen geglätteten Wahrnehmungslautheit-Abschätzungswert durch eine Maximumeinheit (1206),
- das Erzeugen eines Differenzwerts aus dem empfangenen Wahrnehmungslautheit-Abschätzungswert und dem durch die Maximumeinheit (1206) ausgewählten geglätteten Wahrnehmungslautheit-Abschätzungswert,
- das Festsetzen der Grenzfrequenzen für die beiden Tiefpassfilter (1202, 1204) auf erste vorbestimmte oder benutzerdefinierte Werte, falls der Differenzwert einen vorbestimmten Schwellenwert überschreitet, und das Festsetzen der Grenzfrequenzen für die beiden Tiefpassfilter (1202, 1204) auf zweite vorbestimmte oder benutzerdefinierte Werte, falls der Differenzwert unterhalb des vorbestimmten Schwellenwerts liegt, und
- das Einstellen einer Verstärkung des Audiokanals des Audiosegments in Abhängigkeit von dem geglätteten Wahrnehmungslautheit-Abschätzungswert und in Anhängigkeit von einem Wahrnehmungslautheit-Zielpegel (TARGET), wobei ein Verstärkungskorrekturwert als eine Differenz zwischen dem geglätteten Wahrnehmungslautheit-Abschätzungswert und dem Wahrnehmungslautheit-Zielpegel (TARGET) berechnet wird und der Verstärkungskorrekturwert zu dem Audiokanal in dem Frequenzbereich addiert wird.

7. Verfahren nach Anspruch 6, das ferner Folgendes umfasst:

- das Empfangen von Größendaten für mehrere Teilbänder des Audiokanals,
- das Erzeugen eines entsprechenden Skalierungswerts für jedes der mehreren Teilbänder des Signals,
- das Multiplizieren der Größendaten mit dem entsprechenden Skalierungswert, um mehrere skalierte Teilbandgrößen zu erzeugen,
- das Erzeugen eines kombinierten Audiospektrums in Abhängigkeit von den mehreren skalierten Teilbandgrößen und
- das Bestimmen der Wahrnehmungslautheit-Abschätzung in Abhängigkeit von dem erzeugten kombinierten Audiospektrum.

8. Verfahren nach Anspruch 7, wobei das kombinierte Audiospektrum bestimmt wird gemäß der Gleichung: $Y(f) = \sqrt{\sum_{i=1}^{N}(a_i|X_i(f)|^2}$ , wobei

*Y(f)* das kombinierte Audiospektrum darstellt,
*N* eine ganze Zahl ist, welche die Anzahl von Teilbändern darstellt,
*i* eine natürliche Zahl zwischen 1 und N ist,
$a_i$ den Skalierungswert für jedes Teilband darstellt und
$|X_i(f)|$ die Größe jedes Teilbandes darstellt.

**9.** Verfahren nach Anspruch 7, das ferner das Erzeugen eines nach gleicher Lautheit geformten Spektrums durch Skalieren des kombinierten Audiospektrums durch eine Kurve gleicher Lautheit umfasst.

**Revendications**

**1.** Système de commande de volume comprenant :

- une unité d'estimation de volume perceptuel (902) conçue pour déterminer une estimée de volume perceptuel pour un segment audio donné, lequel segment audio comprend un canal audio ; et
- une unité de commande de gain (904) conçue pour recevoir l'estimée de volume perceptuel et conçue pour ajuster un gain du canal audio du segment audio ;

**caractérisé en ce que** :
l'unité de commande de gain (904) comprend :

- un premier filtre passe-bas (1202) et un second filtre passe-bas (1204) chacun conçu pour lisser l'estimée de volume perceptuel reçue ;
- une unité max (1206) conçue pour choisir une sortie maximale du premier filtre passe-bas (1202) et du second filtre passe-bas (1204) en tant que valeur d'estimée de volume perceptuel lissée ; et
- une boucle de retour conçue pour générer une valeur de différence à partir de la valeur d'estimée de volume perceptuel reçue et de la valeur d'estimée de volume perceptuel lissée choisie par l'unité max (1206), et conçue pour définir les fréquences de coupure pour les deux filtres passe-bas (1202, 1204) à des premières valeurs prédéterminées ou définies par l'utilisateur si la valeur de différence dépasse un seuil prédéterminé, et conçue pour définir les fréquences de coupure pour les deux filtres passe-bas (1202, 1204) à des secondes valeurs prédéterminées ou définies par l'utilisateur si la valeur de différence est inférieure au seuil prédéterminé ; dans lequel l'unité de commande de gain (904) est conçue pour ajuster le gain du canal audio du segment audio en fonction de la valeur d'estimée de volume perceptuel lissée et en fonction d'un niveau de volume perceptuel cible (TARGET), une valeur de correction de gain étant calculée comme étant une différence entre la valeur d'estimée de volume perceptuel lissée et le niveau de volume perceptuel cible (TARGET), et la valeur de correction de gain étant ajoutée au canal audio dans le domaine de fréquence.

**2.** Système selon la revendication 1, dans lequel l'unité d'estimation de volume perceptuel (902) comprend en outre plusieurs unités de mise à l'échelle de planéité perceptuelle (1004a, ..., 1004n) qui vont chacune recevoir des données de magnitude pour une sous-bande du canal audio, générer une valeur de mise à l'échelle correspondante, et multiplier les données de magnitude par la valeur de mise à l'échelle correspondante afin de générer plusieurs magnitudes de sous-bande mises à l'échelle, dans lequel :

- l'unité d'estimation de volume perceptuel (902) comprend en outre une unité d'addition de puissance constante (1006) pour recevoir lesdites plusieurs magnitudes de sous-bande mises à l'échelle et générer un spectre audio combiné ; et
- l'unité d'estimation de volume perceptuel (902) est en outre conçue pour déterminer l'estimée de volume perceptuel en fonction du spectre audio combiné généré.

**3.** Système selon la revendication 2, dans lequel le spectre audio combiné est déterminé en fonction de l'équation, $Y(f) = \sqrt{\sum_{i=1}^{N}(a_i|X_i(f)|^2}$ , où :

*Y(f)* représente le spectre audio combiné ;
*N* est un nombre entier représentant le nombre de sous-bandes ;
i est un nombre naturel entre 1 et N ;
$a_i$ représente la valeur de mise à l'échelle de chaque sous-bande ; et
$|X_i(f)|$ représente la magnitude de chaque sous-bande.

**4.** Système selon la revendication 2, comprenant en outre un système de mise en forme de volume égal (1008) pour recevoir le spectre audio combiné et générer un spectre mis en forme de volume égal en mettant à l'échelle le spectre audio combiné à l'aide d'un contour de volume égal.

**5.** Système selon la revendication 4, dans lequel l'unité d'estimation de volume perceptuel (902) est en outre conçue pour déterminer l'estimée de volume perceptuel en fonction du spectre mis en forme de volume égal.

**6.** Procédé de commande de volume consistant à :

- déterminer une estimée de volume perceptuel pour un segment audio donné, le segment audio comprenant un canal audio ;
- recevoir l'estimée de volume perceptuel au niveau d'une unité de commande de gain (904) ;

**caractérisé en ce qu'**il consiste en outre à :

- lisser, à l'aide d'un premier filtre passe-bas (1202) et d'un second filtre passe-bas (1204) de l'unité de commande de gain (904), l'estimée de volume perceptuel reçue ;
- choisir, à l'aide d'une unité max (1206), la sortie maximale du premier filtre passe-bas (1202) et du second filtre passe-bas (1204) en tant que valeur d'estimée de volume perceptuel lissée ;
- générer une valeur de différence à partir de la valeur d'estimée de volume perceptuel reçue et de la valeur d'estimée de volume perceptuel lissée choisie par l'unité max (1206) ;
- définir les fréquences de coupure pour les deux filtres passe-bas (1202, 1204) à des premières valeurs prédéterminées ou définies par l'utilisateur si la valeur de différence dépasse un seuil prédéterminé, et définir les fréquences de coupure pour les deux filtres passe-bas (1202, 1204) à des secondes valeurs prédéterminées ou définies par l'utilisateur si la valeur de différence est inférieure au seuil prédéterminé ; et
- ajuster un gain du canal audio du segment audio en fonction de la valeur d'estimée de volume perceptuel lissée et en fonction d'un niveau de volume perceptuel cible (TARGET), une valeur de correction de gain étant calculée comme étant une différence entre la valeur d'estimée de volume perceptuel lissée et le niveau de volume perceptuel cible (TARGET), et la valeur de correction de gain étant ajoutée au canal audio dans le domaine de fréquence.

**7.** Procédé selon la revendication 6, consistant en outre à :

- recevoir des données de magnitude pour plusieurs sous-bandes du canal audio ;
- générer une valeur de mise à l'échelle correspondante pour chacune desdites plusieurs sous-bandes du signal ;
- multiplier les données de magnitude par la valeur de mise à l'échelle correspondante afin de générer plusieurs magnitudes de sous-bande mises à l'échelle ;
- générer un spectre audio combiné en fonction desdites plusieurs magnitudes de sous-bande mises à l'échelle ; et
- déterminer l'estimée de volume perceptuel en fonction du spectre audio combiné généré.

**8.** Procédé selon la revendication 7, dans lequel le spectre audio combiné est généré en fonction de l'équation $Y(f) = \sqrt{\sum_{i=1}^{N} (a_i |X_i(f)|)^2}$, où :

$Y(f)$ représente le spectre audio combiné ;
$N$ est un nombre entier représentant le nombre de sous-bandes ;
i est un nombre naturel entre 1 et N ;
$a_i$ représente la valeur de mise à l'échelle de chaque sous-bande ; et
$|X_i(f)|$ représente la magnitude de chaque sous-bande.

**9.** Procédé selon la revendication 7, consistant en outre à générer un spectre mis en forme de volume égal en mettant à l'échelle le spectre audio combiné à l'aide d'un contour de volume égal.

FIG. 1

FIG. 2

INVERSE EQUAL LOUDNESS CURVE

FIG. 3

$$\frac{RANK\ 1\ +\ RANK\ 2\ +\ RANK\ 3}{3} = NORMAL\ LEVEL$$

SPEECH HISTOGRAM

| RANK | LEVEL |
|------|-------|
| 1 | -45dB |
| 2 | -20dB |
| 3 | -15dB |
| 4 | -10dB |
| 5 | -25dB |
| 6 | -30dB |
| 7 | -35dB |
| 8 | -40dB |
| 9 | -5dB |
| 10 | -50dB |

NORMAL
LEVEL
-26.7 dB

FIG. 4A

$$\frac{RANK\ 1\ +\ RANK\ 2\ +\ RANK\ 3}{3} = NORMAL\ LEVEL$$

POP HISTOGRAM

| RANK | LEVEL |
|------|-------|
| 1 | -5dB |
| 2 | -25dB |
| 3 | -15dB |
| 4 | -30dB |
| 5 | -20dB |
| 6 | -35dB |
| 7 | -40dB |
| 8 | -10dB |
| 9 | -45dB |
| 10 | -50dB |

NORMAL LEVEL -15 dB

*FIG. 4B*

$$\frac{RANK\ 1\ +\ RANK\ 2\ +\ RANK\ 3}{3} = NORMAL\ LEVEL$$

CLASSICAL HISTOGRAM

| RANK | LEVEL |
|------|-------|
| 1 | -20dB |
| 2 | -15dB |
| 3 | -25dB |
| 4 | -10dB |
| 5 | -30dB |
| 6 | -25dB |
| 7 | -5dB |
| 8 | -40dB |
| 9 | -45dB |
| 10 | -50dB |

NORMAL LEVEL -14 dB

*FIG. 4C*

$e_{in}$

Psy Model

RMS Slow

Max/Min
Max    Min

2)Max    1)Min    3)Target

S/H Hold

RMS Fast

Thr

8)Gate

$Z^{-n}$

Peak    log    Thr

5)Ratio

4)Threshold

$log^{-1}$

RMS Fast

RMS Fast

$Z^{-n}$

Psy Model    Mag Det    log    Thr

7)Ratio

6)Threshold

$log^{-1}$

$e_{out}$

1) Gain Minimum
2) Gain Maximum
3) Target
4) Upper Bound Thresh
5) Upper Bound Ratio
6) Lower Bound Thresh
7) Lower Bound Ratio
8) Leveling Gate

Interim Processing
When the limiter engages, the AGC gate threshold is reduced.
When the compressor disengages, the gate threshold is reduced.

FIG. 5

EP 2 188 986 B1

FIG. 6

FIG. 7

FIG. 8

FIGURE 9

FIGURE 10

$|X_i(f)|$ → PERCEPTUAL BAND GROUPING 1102 → $|X_i(barks)|$ → SPECTRAL FLATNESS MEASURE 1104 → PFM → INVERTER 1106 → $a_i$ → X 1108 → $a_i|X_i(f)|$

**FIGURE 11**    1100

PLE

LP 1 1202
RISE TIME
LP 2 1204
FALL TIME
MAX 1206
SMOOTHED PLE
1208
TARGET
CORRECTION
−
1206
DELTA

1210a
$X_1(f)$ → + → F/T 1212a → $Y_1(t)$
1210b
$X_2(f)$ → + → F/T 1212b → $Y_2(t)$
1210n
$X_N(f)$ → + → F/T 1212n → $Y_N(t)$

**FIGURE 12**    1200

**EP 2 188 986 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006047600 A1